# EUROPEAN PATENT SPECIFICATION

(11) **EP 0 240 215 B1**
(45) Date of publication and mention of the grant of the patent: **13.10.1993**
(21) Application number: 87302441.8
(22) Date of filing: 20.03.1987
(51) Int. Cl.: H05K 7/00, H05K 5/02, H02B 1/04

(54) **Means for mounting a housing module to a control panel**
Mittel zum Montieren eines Gehäusemoduls an einer Schalttafel
Moyens pour le montage d'un module de boîtier à un tableau de commande

(30) Priority: 31.03.1986 US 846391
(43) Date of publication of application: 07.10.1987
(73) Proprietor: INTERNATIONAL CONTROL AUTOMATION FINANCE S.A., Ville de Luxembourg (LU)
(72) Inventor: Hall II, George Robert, Wickliffe Ohio 44092 (US); Richman, Lonnie Joe, Eastlake Ohio 44094 (US)
(74) Representative: Purvis, William Michael Cameron

(56) References cited:
- DE-A- 1 665 012
- FR-A- 2 371 749
- US-A- 3 829 599

## Description

The invention relates to means for mounting a housing module to a control panel.

While advances in electronics have reduced the size and power consumption requirements of many devices used in industry, the need to locate, arrange and mount any given system comprised by such devices has continued. Simplicity of arrangement, ease of initial installation and subsequent removal for service or replacement, efficiency in design (both economic and mechanical) and above all, safety, predominate the concerns facing the designer of a particular system's actual field installation. With the modularization of many electronic components, field installation concerns often centre upon locating the various housing modules that contain the electronic devices in openings in a control panel or instrument console. The electronic modules themselves are then electrically interconnected behind the face of the control panel to complete the system. The housing modules themselves are usually made of steel or aluminum sheet metal. To facilitate the utilization of a standardized design, various engineering standards have settled upon determined sizes of housing modules, clearances and panel openings. Such a system of standardized components assists interchangeability of hardware and minimizes the total number of configurations required.

Given that the housing modules contain electronic instruments or component (hereinafter referred to as electronics), a major concern in any field installation is to ensure that there is sufficient heat dissipation to prevent damage to or destruction of the electronics. The source of this heat is the electronics themselves. This is still a concern notwithstanding the above-mentioned advances in miniaturization and reduction of power consumption requirements, since the miniaturization process itself has led to circuitry and structures of a much denser configuration than previously encountered. Not all electronics generate the same amount of heat during operation. Accordingly, the means employed to handle the problem of heat dissipation will vary depending upon the heat load present. At relatively low levels of heat load, heat dissipation can be handled satisfactorily through radiation and natural convection from the solid walls of the housing modules that contain the electronics. At steady state conditions, the heat generated by the electronics will be equal to the heat being rejected to the surroundings. This will result in the establishment of steady state temperatures for the electronics and the housing modules themselves, which are a function of the materials employed and the ability of the housing module to dissipate heat. If the electronics steady state operating temperature is greater than their design limit, other measures will be necessary. The above-described heat transfer process is "passive" in nature; i.e., other than the structure of the housing module itself, no additional measures are provided to improve the heat dissipation. Of course there are some levels of heat generation that can only be handled by forced cooling with air or other media; these types of aided heat dissipation would be characterized as an "active" design. While the means of the present invention can be used in a force cooling environment (using air or other gaseous media) the design of such equipment to provide the forced cooling is beyond the scope of the present invention.

Another well known passive technique to increase the heat dissipation capability of the housing modules is to provide a plurality of openings in the top and bottom sides of the housing modules, thereby allowing natural convection air currents to pass through the housing module (as well as around and along the sides of the housing module) to assist heat dissipation. While the increased heat dissipation ability of multiple openings in the top and bottom sides of the housing module is quite evident, certain disadvantages became apparent with such a design. Firstly, by being open on the top, the internal electronics are exposed to dripping conductive and/or corrosive liquids, or to particles of dirt, debris or other contaminants, that could fall through the openings and damage the electronics contained therein. Secondly, and of equal importance, the potential for electrical shock to an individual working in the vicinity of the housing modules, due to a tool or other conductive projection falling through one of the openings in the housing modules and contacting the electronics within, is increased. In addition, with either of the above two housing module designs, numerous types of mounting apparatus had been used to secure the housing module to the control panel, undoing to an extent the standardization efforts urged by the above mentioned engineering standards.

According to the invention there is provided means for mounting a housing module to a control panel, comprising:
a mounting bracket assembly including a mounting bracket and means for mounting the mounting bracket to the housing module;
characterised in that:
the mounting bracket has self-compressing means in the form of a bevelled front portion of the mounting bracket to prevent deformation of an intermediate portion of the mounting bracket in a direction away from the mounting module.

Ventilating means can be formed in side portions of the mounting bracket assembly to permit heat dissipation therethrough while preventing direct access to an opening in the housing module.

By shielding a plurality of openings in the top and/or bottom sides of a housing module, dirt, debris, or liquid contaminants face a tortuous path of entry before they can reach the electronics contained therein. Side slots in the mounting bracket assembly, however, can still allow the free flow of natural convection air currents through the housing module that will cool the contained electronics. Further, since the mounting bracket assembly will be in direct contact with the natural convection air currents, it will be heated as well, and will thus provide additional surface area to assist in heat dissipation by radiation and/or convection. Finally, an increased degree of protection from hazardous shock is also provided by the mounting bracket assembly, since a tool or other projection would have extreme difficulty in passing through side slots of the mounting bracket assembly, and thence into openings in the housing module itself. Alternative embodiments could incorporate extended surface fins placed upon the top of the mounting bracket assembly, which would enhance the radiant and/or convective heat dissipative qualities. Such a design might, therefore, favour manufacture via an extrusion process, since the fins could then be created in one step with little difficulty.

The mounting bracket assembly to secure the housing module containing electronics to the control panel can easily be attached to or removed from the control panel in a given installation.

The mounting bracket assembly can be self-aligning, both with respect to the housing module it secures and to the control panel to which the housing module is attached, and can also be self-compressing against the housing module itself.

The mounting bracket assembly provides for heat dissipation and for environmental protection.

The invention is diagrammatically illustrated by way of example in the accompanying drawings, in which:-
Figure 1 is an isometric projection of means for mounting a housing module to a control panel according to the invention;
Figure 2 is a sectional end view corresponding to Figure 1;
Figure 3 is a sectional side view corresponding to Figure 1;
Figure 4 is a plan view of a mounting bracket of the mounting bracket means of Figures 1 to 3;
Figure 5 is a side view corresponding to Figure 4;
Figure 6 is an end view taken on line 6-6 of Figure 5;
Figure 7 is a close-up side view of a bevelled end of the mounting bracket of Figure 6;
Figure 8 is a side view of a slide nut of the means of Figures 1 to 3;
Figure 9 is a plan view corresponding to Figure 8;
Figure 10 is a view of a threaded bolt of the means of Figures 1 to 3; and

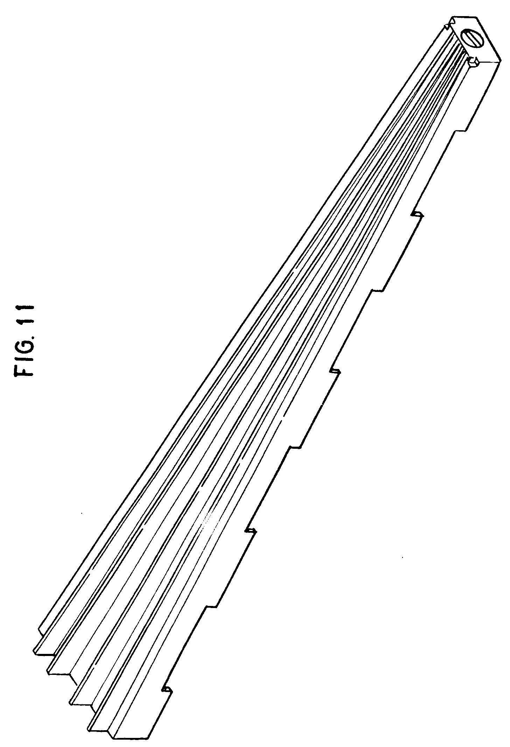

Figure 11 is an alternative embodiment of a mounting bracket of the means of Figures 1 to 3.

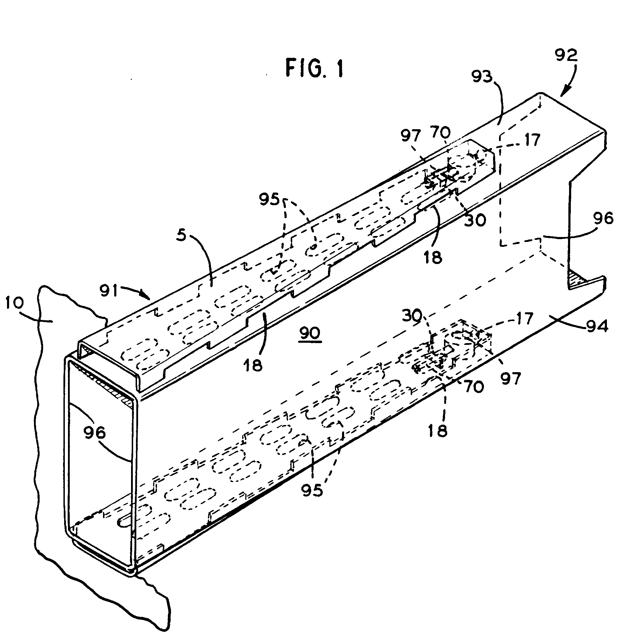

Referring to the drawings and firstly to Figures 1 to 5, a mounting bracket assembly 5, for securing a housing module 90 containing electronics (not shown) to a control panel 110, comprises four sub assemblies: a mounting bracket 10; a guide 30; a slide nut 50; and a threaded bolt 70.

The mounting bracket 10 is made of steel, but other materials such as aluminum or other metals that can be manufactured by a stamping or an extrusion process could also be used. In the former case, the stamped piece would have to undergo a further forming operation to create the desired shape of the mounting bracket 10. The mounting bracket 10 has a wide end, generally indicated at 11, and a narrow end, generally indicated at 12. A notch 19, located at the narrow end 12 of the mounting bracket 10, is present due to the manufacturing requirements then the mounting bracket 10 is formed from a stamping. Once the general shape of the mounting bracket 10 has been stamped out, side walls 13 and 14 are folded inwardly so that they are substantially perpendicular to a top wall 15. Then, an end wall 16 is folded inwardly such that narrow end edges 13B and 14B of the side walls 13 and 14 respectively bear upon the inner face 16B of the end wall 16. The notch 19 prevents a "kinking" or localized deformation of the material at the point of intersection of the two "fold lines" described above. Such a notch 19 would be unnecessary in a mounting bracket 10 made by an extrusion process since, in an extrusion process, the shape could be created as a continuous part of the extrusion process in one step.

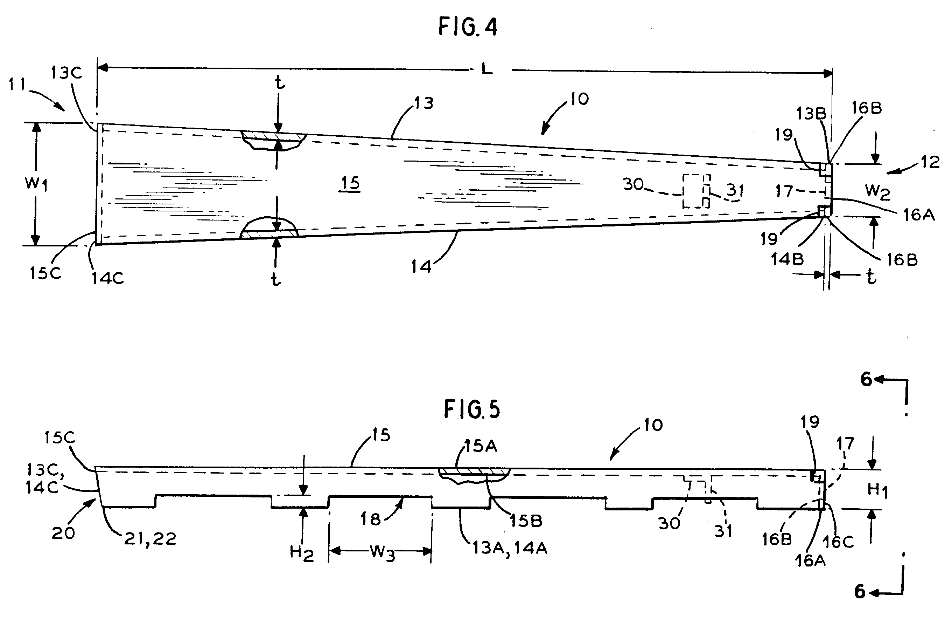

Referring to Figure 4, the preferred dimensions of the wide end 11 and narrow end 12 are W1=60.3mm (2-3/8 inch) and W2=25.4mm (1 inch) respectively, are for standard panel mounted control instruments. Clearly these dimensions can be varied to suit the width and length of other housing modules, as long as the same general proportions are substantially maintained. Together with the side walls 13 and 14, which are identical to each other, the mounting bracket 10, as seen from the top (Figure 4) is trapezoidal in shape, the surfaces of the wide end 11 and narrow end 12 being substantially parallel to each other. As will be seen from Figures 1 to 5, the four walls 13, 14, 15 and 16 of the mounting bracket 10 partially enclose and define a trapezoidal wedge-shaped volume of height H1. The walls 13, 14 and 16 are substantially perpendicular to the top wall 15, and all are of the same, uniform thickness t (within normal manufacturing tolerances). The preferred dimension for the thickness t is 1.5mm (0.060 inch), but this can be varied to suit a particular application if necessary. Measured from the top surface 15 of the top wall 15 to the plane defined by bottom edges 13A, 14A, and 16A, of the walls 13, 14 and 16 respectively, the preferred height H1 of the mounting bracket 10 is 15.9mm (5/8 inch), but this can be increased to suit the overall length of the mounting bracket 10, keeping in mind that excessively slender mounting brackets 10 are to be avoided.

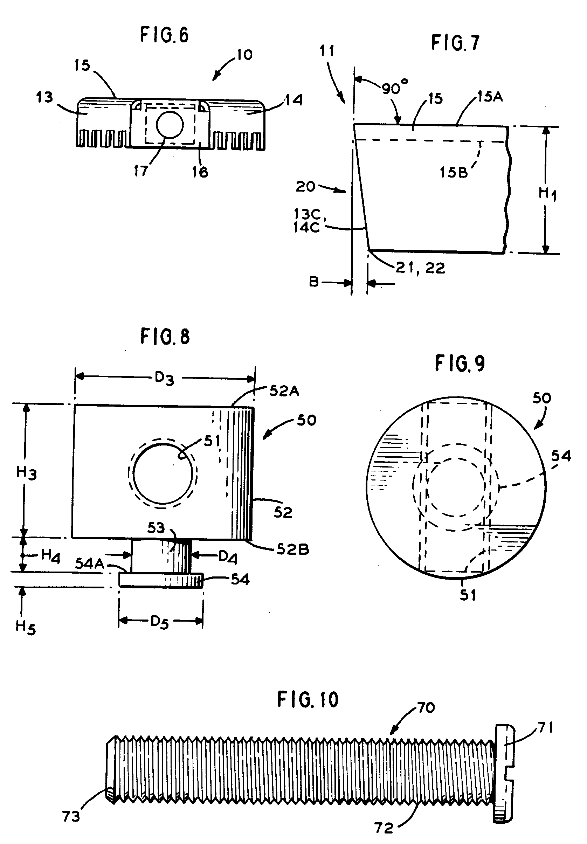

Referring to Figure 5, the side walls 13 and 14 are shown to have a plurality of regularly spaced, rectangular side slots 18 of width W3 and height H2 therein. The side slots 18 permit the ingress and egress of natural convection air currents from a housing module 90, as will be described more fully hereinafter. Preferred dimensions of W3 and H2 are 47.6mm (1-7/8 inch) and 6.4mm (0.25 inch), respectively, although these dimensions are not critical. In a preferred embodiment, the first of such side slots 18 would be placed in the side walls 13 and 14 at approximately 25.4mm (1 inch) from the wide end 11 of the mounting bracket 10, measured along the top wall 15; additional side slots 18 would be spaced approximately 34.9mm (1-3/8 inch) apart and would continue the pattern along the side walls 13 and 14 until the narrow end 12 is approached. The extent and number of the side slots 18 in the mounting bracket 10 depends upon the overall length of the housing module 90 that is to be secured by the mounting bracket assembly 5 to a control panel 110, described more fully hereinafter.

Referring to Figure 6, the end wall 16 is shown to have a centrally disposed hole 17 therein, through which threads 72 of the threaded bolt 70 are intended to pass. The diameter of the hole 17 is designed to be just large enough to permit the threads 72 of the threaded bolt 70 to pass therethrough without engagement of the threads 72 with the sides of the hole 17. It will be noted, however, that a sloted head 71 of the threaded bolt 70 is of sufficient diameter that it will not pass through the hole 17, and yet does not have a diameter which exceeds H1 (so that there is no interference between the slotted head 71 and the housing module 90).

The guide 30 is shown in Figures 4, 5, and 6 as being L-shaped with one leg of the guide 30 permanently attached to the underside surface 15B of the top wall 15, by welding or other suitable means. The other leg of the guid 30 is shown to have a centrally disposed hole 31 located therein. The diameter of the hole 31 is again designed to be just large enough to permit the threads 72 of the threaded bolt 70 to pass therethrough without engagement of the threads 72 of the threaded bolt 70 with the sides of the hole 31. The guide 30 is positioned on the underside surface 15B of the top wall 15 such that the longitudinal axis of the hole 31 lies on the same longitudinal axis as that of the hole 17 located in the end wall 16, and this common longitudinal axis is parallel to the top wall 15 and equidistant from the side walls 13 and 14 at all points. The guide 30 is also positioned at a distance away from the end wall 16 such that the end 73 of the threaded bolt 70, when fully inserted through the hole 17, and thence through the hole 31, will extend past the leg of the guide 30 containing the hole 31 when the mounting bracket assembly 5 is in place and ready to secure the housing module 90.

Turning now to Figure 7, it will be seen that the wide end 11 of the mounting bracket 10 has a bevelled end 20. That is, the plane surface defined by edges 13C, 14C, and 15C of the walls 13, 14 and 15 respectively is not perpendicular to the plane defined by the surface 15A. Instead, the corners 21 and 22, defined by the intersection of the edges 13A and 13C, and 14A and 14C, respectively, are located a distance B measured away from a line segment perpendicular to the surface 15A (and towards the narrow end 12) located at the edge 15C. The preferred dimensions for the distance B is 0.46mm (0.018 inch). As will be described more fully hereinafter, it is this bevelled end 20 that allows the mounting bracket assembly 5 to "bow" towards the housing module 90 when the threaded bolt 70 is tightened, thereby making the mounting bracket assembly 5 self-compressing against the housing module 90.

The slide nut 50 is shown in Figures 8 and 9 and is shown to have three cylindrical shaped sections, each of which shares the same common longitudinal axis of symmetry. These sections are: an upper section 52, a neck section 53, and a lip section 54. Flat, parallel surfaces 52A, 52B, 54A and 54B are all perpendicular to the above-mentioned common longitudinal axis of symmetry and further define the upper section 52, the neck section 53, and the lip section 54. The slide nut 50, therefore, could easily be machined from a single piece of bar stock. The heights of the upper section 52, the neck section 53 and the lip section 54 are shown as H3, H4, and H5, respectively; their respective diameters are shown as D3, D4, and D5. Preferred dimensions for D3, D4, and D5 are 19.1mm (0.75 inch) 6.4mm (0.25 inch) and 9.1mm (0.36 inch) respectively. Preferred dimensions for H3, H4 and H5 are 14.2mm (0.56 inch) 3.6mm (0.14 inch) and 1.5mm (0.06 inch) respectively.

The upper section 52 of the slide nut 50 contains a threaded hole 51, completely passing therethrough, and having a diameter and thread configuration such that it is removably engageable with the threads 72 of the threaded bolt 70. The threaded bolt 70 is shown in Figure 10. The threaded hole 51 has its longitudinal axis of symmetry perpendicular to and intersecting with the above-described common longitudinal axis of symmetry that defines the sections 52, 53 and 54 and is located approximately midway between surfaces the 52A and 52B. The precise location of threaded hole 51 is chosen such that when the surface 52A of the slide nut 50 is slidably engaged with the underside surface 15B of the mounting bracket 10, the longitudinal axis of the threaded hole 51 is coincident with the common longitudinal axis of the hole 31 in the guide 30 and the hole 17 in the mounting bracket 10. Similarly, the dimension H3 of the slide nut 50 is also chosen such that, when the surface 52B and the underside surface 15B are slidably engaged as described above, the surface 52B of the slide nut 50 does not project past the plane defined by the edges 13A, 14A, and 16A of the mounting bracket 10.

The assembly of the mounting bracket assembly 5 will be discussed next. First, for convenience, the mounting bracket 10 can be laid on a surface such that the underside surface 15B is face up. The slide nut 50 is then placed on the mounting bracket 10, between the guide 30 (already attached) and the end wall 16, with the surface 52A of the slide nut 50 in sliding contact with the underside surface 15B, and with the longitudinal axis of the threaded hole 51 lined up with those of the hole 31 and the hole 17. The end 73 of the threaded bolt 70 is then inserted through the hole 17, threadably engaged through the threaded hole 51, and thence through the hole 31.

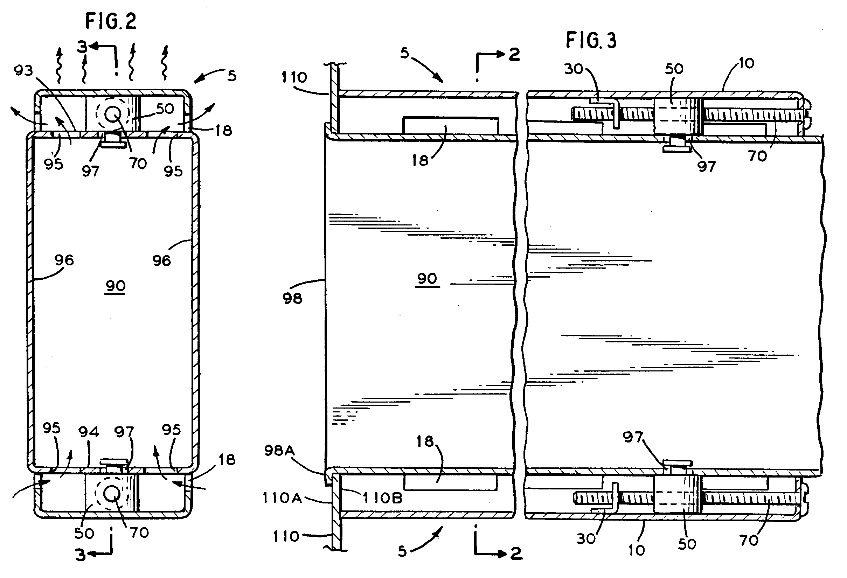

The neck section 53 and the lip section 54 of the slide nut 50 is the means by which the mounting bracket assembly 5 is removably attached to the housing module 90. Figures 1, 2, and 3 show various views of the mounting bracket assembly 5 mounted on the housing module 90; Figure 3 shows the housing module 90 secured to the control panel 110 by the mounting bracket assembly 5.

Referring to Figures 1 and 2, the housing module 90 has a front end, generally indicated at 91, and a rear end, generally indicated at 92. A top side 93 and a bottom side 94 of the housing module 90 are each shown to have a plurality of through openings 95 located therein. The openings 95 allow natural convection air currents to pass through the housing 90 to dissipate heat generated by the electronics contained therein. A hole 97 is present in each of the top side 93 and the bottom side 94 of the housing module 90, centred with respect to sides 96 of the housing module 90 and near the rear end 92. Each hole 97 is removably engageable with the neck section 53 and the lip section 54 of a respective one of the slide nuts 50, thereby attaching the respective mounting bracket assembly 5 to the housing module 90. The diameter of the hole 97 is such that the diameter D5 of the lip section 54 will just pass through it, permitting the neck section 53 of the slide nut 50 to bear upon the edge of the hole 97. Accordingly, the height H4 of the neck section 53 is chosen such that it is just slightly larger than the thickness of the plate material used for the housing module 90. The difference between the diameter D5 of the lip section 54 and the diameter D4 of the neck section 53 (the diameter of D5 being greater than that of D4) is chosen such that the housing module 90 will not easily disengage from the slide nuts 50. The diameter D4 of the neck section 53 is also chosen such that it will not fail when loading due to tightening of the threaded bolt 70 is applied. Similarly, the height H5 of the lip section 54 is chosen so that the weight of the housing module 90 and included electronics will not deform the lip section 54.

Referring to Figure 3, the housing module 90 is designed to be removably secured to the control panel 110. Openings 111 are provided in the control panel 110 that will closely accept the housing module 90. The housing module 90 has, at the front end 91, an outwardly projecting lip 98, extending substantially along the entire perimeter defined by the sides 93, 94 and 96 of the housing module 90. To mount the housing module 90 to the control panel 110, the rear end 92 is first inserted into one of the openings 111 until a rear surface 98A of the lip 98 comes into contact with a front face 110A of the control panel 110, thereby preventing the housing module 90 from passing completely through the opening 111.

An upper and a lower mounting bracket assembly 5 are then placed in contact with the housing module 90, such that for each mounting bracket assembly 5, the wide end 11 of the mounting bracket 10 is in contact with a rear face 110B of the control panel 110. At the same time, the lip section 54 and the neck section 53 of the slide nut 50 are engaged in the hole 97 of the housing module 90. It will be noted that the relative position of the leg of the guide 30 containing the hole 31 is located with respect to the side 16 of the mounting bracket 10 in such a manner that variations in the exact placement of the hole 97 can be easily accommodated through adjustments of the location of the slide nut 50. Once the mounting bracket assembly 5 has been attached to the housing module 90, the threaded bolt 70 is tightened, by means of the slotted head 71. As the threaded bolt 70 is tightened, assuming that the underside surface of the slotted head 71 is bearing upon the surface 16C of the mounting bracket 10, the slide nut 50 will initially be urged towards the narrow end 12 of the mounting bracket 10. The end wall 16 will not bend towards the surface 15B of the mounting bracket 10, since the inner surface 16B bears upon the narrow end edges 13B and 14B. However, since the neck section 53 of the slide nut 50 is bearing upon the edge of the hole 97, the slide nut 50 will not move rearward; instead, the mounting bracket 10 will be urged forward, thereby pressing the wide end 11 against the rear face 110B of the control panel 110, and pressing the lip 98 of the housing module 90 against the front face 110A of the control panel 110, thereby fixedly securing the mounting bracket assembly 5 and the housing module 90 to the control panel 110.

Now the operation of the bevelled end 20 will be discussed. As the threaded bolt 70 is tightened, the first contact between the mounting bracket 10 and the rear face 110A of the control panel 110 occurs only at the edge 15C of the mounting bracket 10. Further tightening of the threaded bolt 70 will attempt to "bow" the mounting bracket 10, but it is restrained from excessive motion since it lies next to the housing module 90 and is held in place from bowing outwardly by the combined actions of the slide nut 50 and the threaded bolt 70, which removably secure the guide 30 and the mounting bracket 10 to the housing module 90. Since the longitudinal axis of the threaded bolt 70 lies between the edge 15C of mounting bracket 10 and the housing module 90, and by virtue of the orientation of the bevelled end 20, any bowing of the mounting bracket 10 will be towards the housing module 90 rather than away from it. The mounting bracket assembly 5 will thus be seen to be self-compressing against the housing module 90.

Since the points of contact on the mounting bracket 10 comprise a line (at the rear face 110B of the control panel 110) and a point lying substantially midway between the ends of the above line (the hole 17 at the narrow end of the mounting bracket 10) the mounting bracket assembly 5 is essentially self-aligning, both with respect to the housing module 90 and to the control panel 110, since the load is centrally and evenly distributed.

## Claims

1. Means for mounting a housing module (90) to a control panel (110), comprising:
a mounting bracket assembly (5) including a mounting bracket (10) and means (30, 50, 70) for mounting the mounting bracket (19) to the housing module (90);
characterised in that the mounting bracket (10) has self-compressing means in the form of a bevelled front portion of the mounting bracket (10) to prevent deformation of an intermediate portion of the mounting bracket (10) in a direction away from the mounting module (90).

2. Means according to claim 1, wherein the mounting bracket (10) comprises:
a first trapezoidal-shaped wall (15) having a narrow edge, a wide edge and two equal edges;
second and third substantially rectangular-shaped walls (13, 14), each attached at one edge of the second and third walls (13, 14) to one of the two equal edges of the first trapezoidal-shaped wall (15) and substantially perpendicular thereto;
a fourth rectangular-shaped wall (16), attached at one edge to the narrow edge of the first trapezoidal-shaped wall (15) and substantially perpendicular thereto, having a first centrally disposed hole (17) therethrough, such that the first (15), second (13), third (14) and fourth (16) walls partially enclose and define a trapezoidal, wedge-shaped volume.

3. Means according to claim 2, wherein the fourth rectangular-shaped wall (16) bears upon an edge (13B, 14B) of each of the second and third substantially rectangular walls (13, 14) to support the fourth rectangular-shaped wall (16).

4. Means according to claim 3, wherein each of the second and third substantially rectangular-shaped walls (13, 14) further comprises:
a plurality of regularly spaced, rectangular side slots (18) located on the edge of the second and third substantially rectangular-shaped walls (13, 14) opposite the edge attached to the first trapezoidal shaped wall (15); and
a bevelled edge (20) comprising said bevelled front portion and located on the end of the second and third substantially rectangular-shaped walls (13, 14) opposite the end having an edge (13B, 14B) bearing upon the fourth rectangular-shaped side (16).

5. Means according to any one of claims 2 to 4, wherein the means for mounting the mounting bracket (10) to the housing module (90) comprise:
a slide nut (50) having a threaded hole (51) completely passing through an upper section (52) of a first diameter (D3);
an L-shaped guide (30), secured by a first leg to the underside surface (15) of the mounting bracket (10) and having, in a second leg, a second centrally disposed through hole (31), the second centrally disposed through hole (31) having an axis of symmetry coincident with that of first centrally disposed hole (17) located in the fourth rectangular-shaped wall (16) of the mounting bracket (10); and
a threaded bolt (70) to pass through the first centrally disposed hole (17), removably engaging the threaded hole (51) in the slide nut (50), and passing through the second centrally disposed through hole (31) in the L-shaped guide (30).

6. Means according to claim 5, wherein the slide nut (50) further comprises:
a neck section (53) of a second diameter (D4), smaller than the first diameter (D3) of the upper section (52); and
a lip section (54) of a third diameter (D5), larger than the second diameter (D4) of the neck section (53) of the slide nut (50), removably to engage in a hole (97) in the housing module (90) having a diameter larger than the third diameter (D5) to mount the mounting bracket (10) to the housing module (90).

7. Means according to any one of claims 2 to 6, wherein to increase the heat transfer area of the mounting bracket (10), the mounting bracket (10) has a wedge-shaped top surface (15), locatable along a side of the housing module (90), the top surface including a plurality of fins extending along the top surface with the fins extending radially along the length of the wedge-shaped top surface.

8. Means according to claim 1, wherein:
to allow natural convection through the housing module (90) while preventing direct access to the housing module (90), the housing module (90) has at least one opening (95) to permit heat dissipation therethrough;
the mounting bracket assembly (5) has a top wall (15) supported away from the housing module (90) by a pair of side portions (13, 14) and is located on the housing module so as spacedly to cover the opening (95) of the housing module with the top wall (15) of the mounting bracket assembly (5); and
ventilating means (18) are formed in the side portions (13, 14) of the mounting bracket assembly (5) to permit heat dissipation therethrough while preventing direct access to the opening (95) in the housing module (90).

9. Means according to claim 8, wherein the ventilating means comprise a series of rectangular slots (18) located in the edges of the side portions (13, 14) nearer to the housing module (90).

## Patentansprüche

1. Vorrichtung zum Montieren eines Gehäusemoduls (90) an einer Schalttafel (110) mit
einer Befestigungsträgeranordnung (5) mit einem Befestigungsträger (10) und Einrichtungen (30,50,70) zur Befestigung des Befestigungsträgers (19) an dem Gehäusemodul (90),
**dadurch gekennzeichnet,** daß der Befestigungsträger (10) selbstkomprimierende Einrichtungen in der Form eines abgeschrägten Vorderabschnittes des Befestigungsträgers (10) hat, um eine Verformung eines Zwischenabschnittes des Befestigungsträgers (10) in einer Richtung von dem Gehäusemodul (90) weg zu verhindern.

2. Vorrichtung nach Anspruch 1, bei der der Befestigungsträger (10)
eine erste trapezoidförmige Wand (15) mit einer schmalen Kante, einer breiten Kante und zwei gleichen Kanten,
zweite und dritte im wesentlichen rechteckig geformte Wände (13, 14), von denen jede an einer Kante der zweiten und dritten Wände (13,14) mit einer der gleichen Kanten der ersten trapezoidförmigen Wand (15) und im wesentlichen senkrecht hierzu verbunden ist,
und eine vierte rechteckig geformte Wand (16), die an einer Kante mit der schmalen Kante der ersten trapezoidförmigen Wand (15) und im wesentlichen senkrecht hierzu verbunden ist und eine erste mittig angeordnete durchgehende Öffnung (17) derart aufweist, daß die erste (15), zweite (13), dritte (14) und vierte (16) Wand teilweise ein trapezoidförmiges, keilförmiges Volumen einschließen und begrenzen, umfaßt.

3. Vorrichtung nach Anspruch 2, bei der sich die vierte rechteckig geformte Wand (16) auf eine Kante (13B,14B) jeder der zweiten und dritten im wesentlichen rechteckigen Wände (13, 14) abstützt, um die vierte rechteckig geformte Wand (16) zu unterstützen.

4. Vorrichtung nach Anspruch 3, bei der die zweiten und dritten im wesentlichen rechteckig geformten Wände (13,14) weiterhin
mehrere in regelmäßigem Abstand angeordnete rechteckige Seitenschlitze (18), die auf der Kante der zweiten und dritten im wesentlichen rechteckig geformten Wände (13,14) gegenüber der Kante, die mit der ersten trapezoidförmigen Wand (15) verbunden ist, angeordnet sind, und
eine abgeschrägte Kante (20), die den abgeschrägten Vorderabschnitt umfaßt und an dem Ende der zweiten und dritten im wesentlichen rechteckig geformten Wände (13, 14) gegenüber dem Ende angeordnet ist, das eine Kante (13B,14B) hat, welche sich auf der vierten rechteckig geformten Wand (16) abstützt, umfaßt.

5. Vorrichtung nach einem der Ansprüche 2 bis 4, bei der die Einrichtung zur Befestigung des Befestigungsträgers (10) an dem Gehäusemodul (90)
eine Gleitmutter (50) mit einem mit Gewinde versehenen Loch (51), das vollständig durch einen oberen Abschnitt (52) des ersten Durchmessers (D3) hindurchgeht,
eine L-förmige Führung (30), die mit einem ersten Schenkel an der unteren Oberfläche (15) des Befestigungsträgers (10) befestigt ist und in einem zweiten Schenkel ein zweites mittig angeordnetes durchgehendes Loch (31) hat, wobei das zweite mittig angeordnete durchgehende Loch (31) eine Symmetrieachse hat, die mit jener des ersten mittig angeordneten Loches (17) zusammenfällt, welches in der vierten rechteckig geformten Wand (16) des Befestigungsträgers (10) angeordnet ist, und
einen Schraubenbolzen (70), der durch das erste mittig angeordnete Loch (17) geht, lösbar in das mit Gewinde versehene Loch (51) in der Gleitmutter (50) eingreift und durch das zweite mittig angeordnete durchgehende Loch (31) in der L-förmigen Führung (30) hindurchgeht, umfaßt.

6. Vorrichtung nach Anspruch 5, bei der die Gleitmutter (50) weiterhin
einen Halsabschnitt (53) mit einem Zweiten Durchmesser (D4) kleiner als der erste Durchmesser (D3) des oberen Abschnittes (52) und
einen Lippenabschnitt (54) mit einem dritten Durchmesser (D5) größer als der zweite Durchmesser (D4) des Halsabschnittes (53) der Gleitmutter (50), um lösbar in ein Loch (97) in dem Gehäusemodul (90) mit einem Durchmesser größer als der dritte Durchmesser (D5) einzugreifen und so den Befestigungsträger (10) an dem Gehäusemodul (90) zu befestigen, umfaßt.

7. Vorrichtung nach einem der Ansprüche 2 bis 6, bei der zur Vergrößerung der Wärmeüberführungsfläche des Befestigungsträgers (10) der Befestigungsträger (10) eine keilförmige obere Oberfläche (15) hat, die entlang einer Seite des Gehäusemoduls (90) angeordnet werden kann, wobei die obere Oberfläche mehrere sich entlang der oberen Oberfläche erstreckende Rippen einschließt und sich die Rippen radial entlang der Länge der keilförmigen oberen Oberfläche erstrecken.

8. Vorrichtung nach Anspruch 1, bei der
um eine natürliche Konvexion durch den Gehäusemodul (90) zu gestatten, während direkter Zugang zu dem Gehäusemodul (90) verhindert wird, der Gehäusemodul (90) wenigstens eine Öffnung (95) hat, um eine Wärmeausbreitung durch sie hindurch zu erlauben,
die Befestigungsträgeranordnung (5) eine obere Wand (15) hat, die von dem Gehäusemodul (90) weg durch ein Paar Seitenabschnitte (13,14) unterstützt wird und derartig an dem Gehäusemodul angeordnet ist, daß sie im Abstand die Öffnung (95) des Gehäusemoduls mit der oberen Wand (15) der Befestigungsträgeranordnung (5) bedeckt, und
Lüftungseinrichtungen (18) in den Seitenabschnitten (13,14) der Befestigungstägeranordnung (5) ausgebildet sind, um eine Wärmeverteilung durch sie zu gestatten, während eine direkter Zugang zu der Öffnung (95) in dem Gehäusemodul (90) verhindert wird.

9. Vorrichtung nach Anspruch 8, bei der die Lüftungseinrichtung eine Reihe rechteckiger Schlitze (18) umfaßt, die in den Kanten der Seitenabschnitte (13,14 ) näher dem Gehäusemodul (90) angeordnet sind.

## Revendications

1. Moyen pour monter un module de boîtier (90) sur un tableau de commande (110), comprenant :
un ensemble support de montage (5) incluant un support de montage (10) et un moyen (30, 50, 70) pour monter le support de montage (19) sur le module de boîtier (90) ;
caractérisé en ce que le support de montage (10) possède un moyen auto-serrant sous la forme d'une partie avant en biseau du support de montage (10) pour empêcher la déformation d'une partie intermédiaire du support de montage (10) dans une direction s'écartant du module de montage (90).

2. Moyen selon la revendication 1, dans lequel le support de montage (10) comprend :
une première paroi de forme trapézoïdale (15) ayant un bord étroit, un bord large, et deux bords égaux ;
des deuxième et troisième parois de forme sensiblement rectangulaire (13, 14), chacune fixée au droit d'un bord des deuxième et troisième parois (13, 14) à l'un des deux bords égaux de la première paroi de forme trapézoïdale (15) et sensiblement perpendiculairement à celle-ci ;
une quatrième paroi de forme rectangulaire (16), fixée au droit d'un bord au bord étroit de la première paroi de forme trapézoïdale (15) et sensiblement perpendiculairement à celle-ci, comportant un premier trou disposé de façon centrale (17) la traversant, de telle manière que les première (15), deuxième (13), troisième (14), et quatrième (16) parois enferment partiellement et définissent un volume trapézoïdal en forme de coin.

3. Moyen selon la revendication 2, dans lequel la quatrième paroi de forme rectangulaire (16) porte sur un bord (13B, 14B) de chacune des deuxième et troisième parois sensiblement rectangulaire (13, 14) pour supporter la quatrième paroi de forme rectangulaire (16).

4. Moyen selon la revendication 3, dans lequel chacune des deuxième et troisième parois de forme sensiblement rectangulaire (13, 14) comprend en outre :
une pluralité de fentes latérales rectangulaires (18), régulièrement espacées, situées sur le bord des deuxième et troisième parois de forme sensiblement rectangulaire (13, 14) opposé au bord fixé à la première paroi de forme trapézoïdale (15) ; et
un bord en biseau (20) comprenant ladite partie avant en biseau et situé sur l'extrémité des deuxième et troisième parois de forme sensiblement rectangulaire (13, 14) opposée à l'extrémité ayant un bord (13B, 14B) portant sur le quatrième côté de forme rectangulaire (16).

5. Moyen selon l'une quelconque des revendications 2 à 4, dans lequel le moyen pour monter le support de montage (10) sur le module de boîtier (90) comprend :
un écrou coulissant (50) ayant un trou taraudé (51) traversant complètement une partie supérieure (52) d'un premier diamètre (D3) ;
un guide en forme de L (30), fixé par une première jambe à la surface inférieure (15) du support de montage (10) et comportant, dans une seconde jambe, un second trou traversant situé de manière centrale (31), le second trou traversant situé de manière centrale (31) ayant un axe de symétrie coïncidant avec celui du premier trou disposé de manière centrale (17) situé dans la quatrième paroi de forme rectangulaire (16) du support de montage (10) ; et
une tige filetée (70) pour traverser le premier trou disposé de manière centrale (17), pour coopérer de façon amovible avec le trou taraudé (51) dans l'écrou coulissant (50) et pour passer dans le second trou traversant disposé de manière centrale (31) dans le guide en forme de L (30).

6. Moyen selon la revendication 5, dans lequel l'écrou coulissant (50) comprend en outre :
une partie col (53) d'un deuxième diamètre (D4) plus petit que le premier diamètre (D3) de la partie supérieure (52) ; et
une partie lèvre (54) d'un troisième diamètre (D5) plus grand que le deuxième diamètre (D4) de la partie col (53) de l'écrou coulissant (50), pour coopérer de façon amovible avec un trou (97) dans le module de boîtier (90) ayant un diamètre plus grand que le troisième diamètre (D5) pour monter le support de montage (10) sur le module de boîtier (90).

7. Moyen selon l'une quelconque des revendications 2 à 6, dans lequel, pour augmenter la superficie de transfert de chaleur du support de montage (10), le support de montage (10) possède une surface supérieure en forme de coin (15), pouvant se loger le long d'un côté du module de boîtier (90), la surface supérieure incluant une pluralité d'ailettes s'étendant le long de la surface supérieure, les ailettes s'étendant radialement suivant la longueur de la surface supérieure en forme de coin.

8. Moyen selon la revendication 1, dans lequel :
pour permettre la convection naturelle à travers le module de boîtier (90) tout en empêchant l'accès direct au module de boîtier (90), le module de boîtier (90) possède au moins une ouverture (95) pour permettre, par elle, la dissipation de chaleur ;
dans lequel l'ensemble support de montage (5) possède une paroi supérieure (15) supportée à distance du module de boîtier (90) par une paire de parties latérales (13, 14) et qui est située sur le module de boîtier de manière à recouvrir de façon espacée l'ouverture (95) du module de boîtier avec la paroi supérieure (15) de l'ensemble support de montage (5) ; et
dans lequel des moyens de ventilation (18) sont formés dans les parties latérales (13, 14) de l'ensemble support de montage (5) pour permettre par eux la dissipation de chaleur tout en empêchant l'accès direct à l'ouverture (95) dans le module de boîtier (90).

9. Moyen selon la revendication 8, dans lequel les moyens de ventilation comprennent une série de fentes rectangulaires (18) situées dans les bords des parties latérales (13, 14) plus près du module de boîtier (90).
